# EUROPEAN PATENT APPLICATION

(11) **EP 3 073 573 A1**
(43) Date of publication of application: **28.09.2016**
(21) Application number: 14861998.4
(22) Date of filing: 17.11.2014
(51) Int. Cl.: H01Q 7/06

(54) **METHOD FOR MANUFACTURING COIL ANTENNA AND METHOD FOR MANUFACTURING COIL ANTENNA MOUNTING BODY**

(30) Priority: 18.11.2013 JP 2013237676
(71) Applicant: Ricoh Company, Ltd., Tokyo 143-8555 (JP)
(72) Inventor: SEIGENJI, Takashi, Tokyo 143-8555 (JP); OTSUKI, Takashi, Tokyo 143-8555 (JP); INUI, Tetsuo, Tokyo 143-8555 (JP); ITOH, Naohiro, Tokyo 143-8555 (JP); NAKAMURA, Yasuyuki, Tokyo 143-8555 (JP)
(74) Representative: Schwabe - Sandmair - Marx
(86) International application number: PCT/JP2014/080371
(87) International publication number: WO 2015/072568

(57) **Abstract**

A method of manufacturing a coil antenna that includes a flexible plate-shaped coil antenna body containing a magnetic material, and a coil wire wound around the coil antenna body in a direction perpendicular to a longitudinal direction of the coil antenna body so as to form a loop, includes the steps of temporarily fixing a terminal end of the coil wire to the coil antenna body and performing treatment on part of the coil wire that comes into contact with a connection part of a mounting base on which the coil antenna is to be mounted, so that the coil antenna is electrically connectable to the mounting base.

## Description

### Technical Field

The present invention relates to methods of manufacturing a coil antenna and methods of manufacturing a coil antenna package.

### Background Art

Recent years have seen a rapid diffusion of portable-terminal radio communications devices such as cellular phones, smartphones, and tablet personal computer (PC) terminals. Because these devices are both being reduced in size and becoming functionally more sophisticated at the same time, devices to be mounted on these devices also are required to be reduced in size and thickness. In particular, communication antennas to be mounted on these devices are required to be reduced in thickness.

Antennas to be mounted on smartphones include loop antennas and spiral antennas. Of these, spiral antennas are believed to increase a communication distance.

In the case of forming a low-profile antenna using a spiral antenna, it is necessary to reduce the thickness of a magnetic material that serves as a core around which a coil is wound. In the case of forming a core using a ferrite material having normal stiffness as a magnetic material, however, the core may be broken at the time of its manufacture or its incorporation into a product, thus being difficult to put to practical use.

Therefore, techniques have been known that employ a bar-shaped or sheet-shaped magnetic material that holds small pieces of ferrite whose length of each side is a few millimeters in PET resin (for example, Patent Document 1 and Patent Document 2 listed below).

Patent Document 1 discloses, in response to a demand for antenna flexibility, an antenna core that includes magnetic members each formed of a thin film magnetic material to which resin is applied, a flexible tube that hermetically seals a magnetic core part into which the magnetic members are stacked without being fixed to each other, and an oil solution interposed between the magnetic core part and the flexible tube. It is illustrated that according to this antenna core, it is possible to prevent generation of cracks and damage and to stabilize the shape, so that it is possible to obtain good antenna characteristics.

Patent Document 2 discloses, in response to demands for shock resistance and a diversity of shapes, an antenna core formed of an insulating soft magnetic material that includes soft magnetic material powder and an organic binder. It is illustrated that as a result of using an insulating soft magnetic material having particular magnetic permeability frequency characteristics, a coil antenna including the antenna core obtains better characteristics than conventional coil antennas and has good shock resistance, processability, and mountability.

### [Prior Art Documents]

### [Patent Documents]

[Patent Document 1] Japanese Laid-Open Patent Application No. 2012-105092
[Patent Document 2] Japanese Laid-Open Patent Application No. 2005-317674

### Summary of Invention

### Problems to be Solved by the Invention

While it is possible to reduce the thickness of a coil antenna (spiral antenna) that uses a flexible plate-shaped (sheet-shaped) magnetic material as a core, an antenna package formed by connecting the coil antenna to a board also is desired to be kept thin. Furthermore, it is also desired that the antenna package be manufactured at good efficiency.

Patent Document 1 and Patent Document 2 are silent about a method of treating the terminal ends of a coil wire wound around an antenna core. The method of treating the terminal ends of a coil wire is believed to affect process efficiency and also the thickness of an antenna package.

For example, soldering the terminal ends of a coil wire individually to an electronic board has the problem of making manufacture inefficient and making the reduction of thickness difficult.

In view of the above-described problems, the present invention has an object of providing a method of manufacturing an efficiently mountable coil antenna using a flexible plate-shaped magnetic material as a core while keeping the coil antenna low-profile.

### Means for Solving the Problems

According to an aspect of the present invention, a method of manufacturing a coil antenna that includes a flexible plate-shaped coil antenna body containing a magnetic material, and a coil wire wound around the coil antenna body in a direction perpendicular to a longitudinal direction of the coil antenna body so as to form a loop, includes the steps of temporarily fixing a terminal end of the coil wire to the coil antenna body and performing treatment on part of the coil wire that comes into contact with a connection part of a mounting base on which the coil antenna is to be mounted, so that the coil antenna is electrically connectable to the mounting base.

According to an aspect of the present invention, a method of manufacturing a coil antenna package that includes a coil antenna including a flexible plate-shaped coil antenna body containing a magnetic material, and a coil wire wound around the coil antenna body in a direction perpendicular to a longitudinal direction of the coil antenna body so as to form a loop; and a mounting base on which the coil antenna is surface-mounted, the mounting base including a connection part at a position where the mounting base is connected to the coil antenna, includes the steps of temporarily fixing a terminal end of the coil wire to the coil antenna body, performing treatment on part of the coil wire that comes into contact with the connection part of the mounting base, so that the coil antenna is electrically connectable to the mounting base, and disposing the coil antenna on the mounting base so that the part of the coil wire comes into contact with the connection part, and joining the coil antenna to the mounting base with solder flow.

### Effects of the Invention

According to an aspect of the present invention, a method of manufacturing an efficiently mountable coil antenna using a flexible plate-shaped magnetic material as a core while keeping the coil antenna low-profile is provided.

According to an aspect of the present invention, a method of manufacturing a coil antenna package that suppresses an increase in thickness due to the joining of a coil antenna and a mounting base is provided.

### Brief Description of Drawings

FIG. 1 is an exterior perspective view of an example of a coil antenna before the coil antenna is mounted on a mounting base according to a method of manufacturing a coil antenna of a first embodiment.
FIG. 2 is an exterior perspective view of another example of the coil antenna before the coil antenna is mounted on the mounting base according to the method of manufacturing a coil antenna of the first embodiment.
FIG. 3 is a plan view of an example of the coil antenna before the coil antenna is mounted on the mounting base according to a second embodiment.
FIG. 4 is a plan view of another example of the coil antenna before the coil antenna is mounted on the mounting base according to the second embodiment.
FIG. 5 is a diagram illustrating a state before the coil antenna is mounted on the mounting base according to the second embodiment.
FIG. 6 is a schematic plan view of an assembly board of a flexible printed circuit board according to a third embodiment.
FIG. 7 is a diagram illustrating a configuration of a coil antenna body according to the third embodiment.
FIG. 8 is a schematic diagram illustrating the coil antenna body in which the flexible printed circuit board is stacked on a magnetic material core according to the third embodiment.
FIG. 9 is a schematic diagram illustrating an example of the coil antenna according to the third embodiment.
FIG. 10 is a schematic diagram illustrating another example of the coil antenna according to the third embodiment.
FIG. 11 is a diagram illustrating the coil antenna and other parts before being mounted on the mounting base according to the third embodiment.

### Modes for Carrying Out the Invention

A description is given below, with reference to the accompanying drawings, of embodiments of the present invention. In the following description, the same elements are referred to by the same reference numeral.

According to an aspect of the present invention, a method of manufacturing a coil antenna that includes a flexible plate-shaped coil antenna body containing a magnetic material, and a coil wire wound around the coil antenna body in a direction perpendicular to a longitudinal direction of the coil antenna body so as to form a loop includes the steps of temporarily fixing a terminal end of the coil wire to the coil antenna body and performing treatment on part of the coil wire that comes into contact with a connection part of a mounting base on which the coil antenna is to be mounted, so that the coil antenna is electrically connectable to the mounting base.

According to an aspect of the present invention, a method of manufacturing a coil antenna package that includes a coil antenna including a flexible plate-shaped coil antenna body containing a magnetic material, and a coil wire wound around the coil antenna body in a direction perpendicular to a longitudinal direction of the coil antenna body so as to form a loop; and a mounting base on which the coil antenna is surface-mounted, the mounting base including a connection part at a position where the mounting base is connected to the coil antenna, includes the steps of temporarily fixing a terminal end of the coil wire to the coil antenna body, performing treatment on part of the coil wire that comes into contact with the connection part of the mounting base, so that the coil antenna is electrically connectable to the mounting base, and disposing the coil antenna on the mounting base so that the part of the coil wire comes into contact with the connection part, and joining the coil antenna to the mounting base with solder flow.

### [First Embodiment]

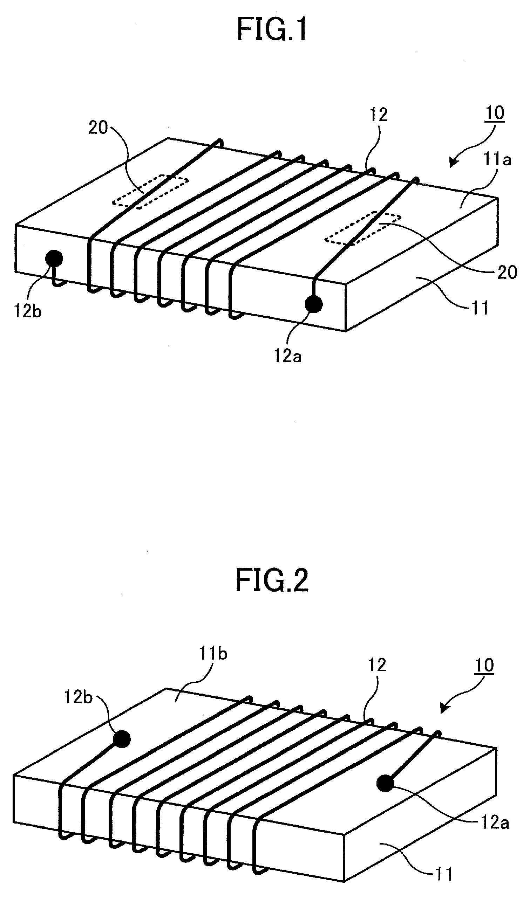

FIG. 1 and FIG. 2 are perspective views each illustrating the exterior of a coil antenna before the coil antenna is mounted on a mounting base according to a method of manufacturing a coil antenna of a first embodiment. Referring to FIG. 1 and FIG. 2, a coil antenna 10 includes a flexible plate-shaped coil antenna body 11 containing a magnetic material, and a coil wire 12 wound around the coil antenna body 11 in a transverse direction (a direction perpendicular to a longitudinal direction) of the coil antenna body 11 so as to form a loop.

A method of manufacturing the coil antenna 10 includes a process of temporarily fixing terminal ends 12a and 12b of the coil wire 12 to the coil antenna body 11 and a process of performing treatment on at least part of the coil wire 12 that comes into contact with a connection part of a mounting base (not illustrated) on which the coil antenna 10 is to be mounted, so that the coil antenna 10 is electrically connectable to the mounting base.

Referring to FIG. 1 and FIG. 2, according to this embodiment, the terminal ends 12a and 12b of the coil wire 12 of the coil antenna 10 are temporarily fixed to a surface other than a surface 11a of the coil antenna body 11 that faces (connects to) the mounting base when the coil antenna 10 is disposed on the mounting base.

The coil antenna body 11 includes a surface 11b that is opposite to the surface 11a that faces the mounting base. Furthermore, the coil antenna 10 includes antenna connection pattern contact parts 20 at positions corresponding to connection parts (antenna connection patterns) formed on the mounting base.

The terminal ends 12a and 12b of the coil wire 12 are temporarily fixed to a surface of the coil antenna body 11 using an adhesive agent or the like. The surface to which the terminal ends 12a and 12b are temporarily fixed is preferably a surface of the coil antenna body 11 adjoining the surface 11a that faces (connects to) the mounting base as illustrated in FIG. 1, in order to minimize an increase in the thickness of the coil antenna 10 after its mounting on the mounting base. If such an arrangement is difficult for structural reasons, however, the surface to which the terminal ends 12a and 12b are temporarily fixed may be the surface 11b opposite to the surface 11a that connects to the mounting base as illustrated in FIG. 2, on condition that the amount of application of an adhesive agent is minimized.

After temporary fixation of the terminal ends 12a and 12b of the coil wire 12, pre-treatment is performed on at least parts of the coil wire 12, placed on the surface 11a that connects to the mounting base, which parts are in the antenna connection pattern contact parts 20 at positions corresponding to the antenna connection patterns formed on the mounting base.

The pre-treatment is performed so as to make the coil antenna 10 and the mounting base easily connectable in a solder flow process, and includes, for example, formation of pre-soldered parts and removal of coats of coated copper wires.

According to this embodiment, the coil antenna body 11 may be a flexible plate-shaped body containing a magnetic material. Examples of magnetic materials include ferrite, iron, nickel, cobalt, and their alloys, among which ferrite is preferable.

As the coil wire 12, for example, a copper wire, preferably, a coated copper wire, may be used.

### [Second Embodiment]

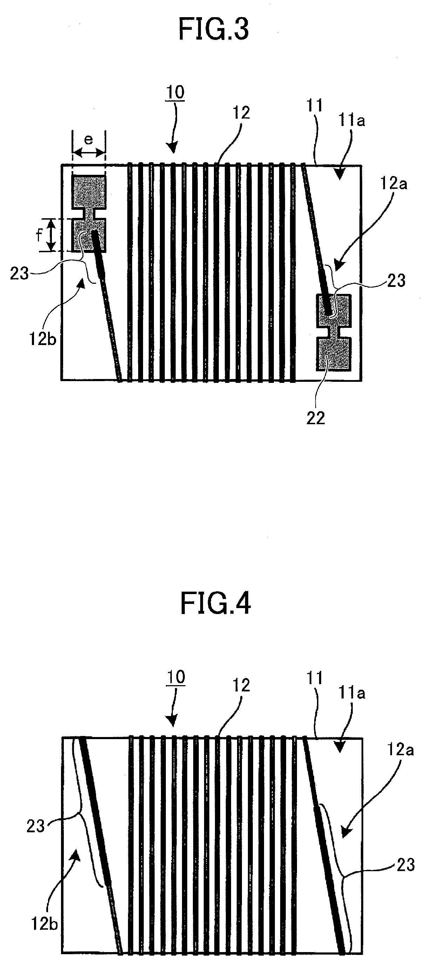

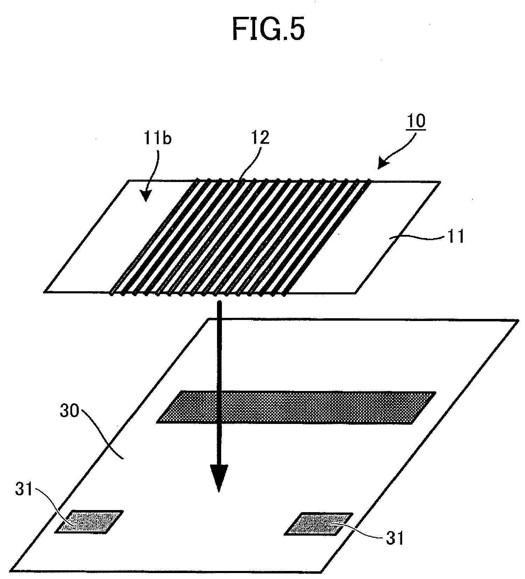

FIG. 3 and FIG. 4 are plan views of a coil antenna before mounting the coil antenna on a mounting base and FIG. 5 is a diagram illustrating a state before mounting the coil antenna on the mounting base, according to a method of manufacturing a coil antenna and a method of manufacturing a coil antenna package of a second embodiment.

A method of manufacturing a coil antenna according to this embodiment includes a process of temporarily fixing the terminal ends 12a and 12b of the coil wire 12 to the coil antenna body 11 and a process of performing treatment on at least part of the coil wire 12 that comes into contact with connection parts (antenna connection patterns) 31 of a mounting base 30 on which the coil antenna 10 is to be mounted, so that the coil antenna 10 is electrically connectable to the mounting base 30, where the treatment forms pre-soldered parts 23.

FIG. 3 illustrates an example of the coil antenna 10 that employs, as the coil antenna body 11, a magnetic material provided with SMT (surface mounting) lands 22 (antenna terminals) by printing a Ag thick film. The coil wire 12 is wound around the coil antenna body 11. The terminal ends 12a and 12b of the coil wire 12 are pre-soldered and are connected by high-temperature soldering or welded by spot welding to the SMT lands 22.

The SMT lands 22 are not limited to particular dimensions. For example, a dimension in the longitudinal direction of the coil antenna body 11, indicated by double-headed arrow e in FIG. 3, may be 1.0 mm and a dimension in a direction perpendicular to the transverse direction of the coil antenna body 11, indicated by double-headed arrow f in FIG. 3, may be 1.0 mm.

The coil antenna body 11 may employ sintered ferrite as a magnetic material. In this case, the coil antenna body 11 may be manufactured by performing half-cutting on the magnetic material, firing the magnetic material after printing SMT lands on half-cut sections, and applying PET resin having openings for the SMT lands onto the magnetic material.

A coil antenna package is manufactured by joining the coil antenna 10 of FIG. 3 to the mounting base 30 as illustrated in FIG. 5.

According to a method of manufacturing a coil antenna package of this embodiment, the terminal ends 12a and 12b of the coil wire 12 are connected by high-temperature soldering or welded by spot welding to the SMT lands 22 formed on the coil antenna body 11, and the coil antenna 10 is thereafter disposed on the mounting base 30 so that the SMT lands 22 to which the coil wire 12 is connected come into contact with the antenna connection patterns 31, and is joined, together with other mounting parts, to the mounting base 30 with solder flow.

FIG. 4 illustrates an example of the coil antenna 10 that employs, for example, a magnetic material of resin-coated ferrite as the coil antenna body 11. The coil wire 12 is wound around the coil antenna body 11, and the terminal ends 12a and 12b of the coil wire 12 are pre-soldered. The coil wire 12 is fixed to the coil antenna body 11 by thermocompression bonding to the resin coat.

A coil antenna package is manufactured by joining the coil antenna 10 of FIG. 4 to the mounting base 30 as illustrated in FIG. 5.

According to a method of manufacturing a coil antenna package of this embodiment, the terminal ends 12a and 12b of the coil wire 12 are pre-soldered, and the coil antenna 10 is thereafter disposed on the mounting base 30 so that the pre-soldered parts 23 come into contact with the antenna connection patterns 31, and is joined, together with other mounting parts, to the mounting base 30 with solder flow.

### [Third Embodiment]

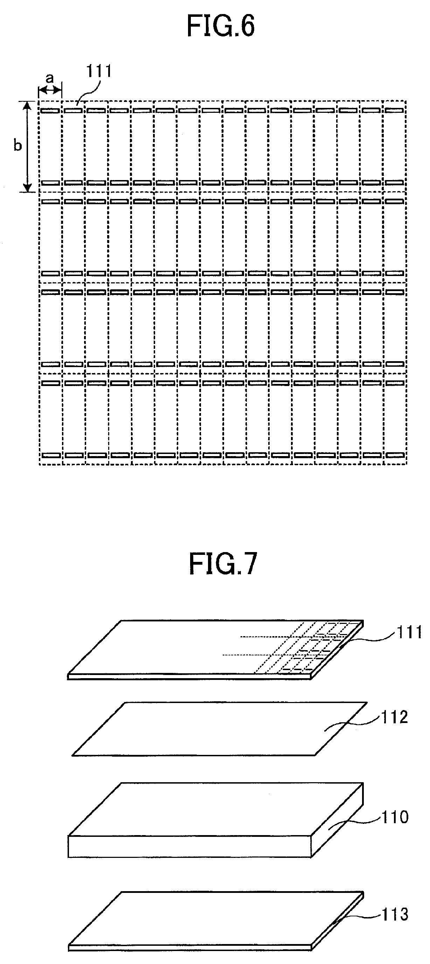

A description is given, with reference to FIG. 6, FIG. 7, FIG. 8, FIG. 9, FIG. 10 and FIG. 11, of a third embodiment.

According to a method of manufacturing a coil antenna of this embodiment, the coil antenna 10 is manufactured where the coil antenna body 11 includes a plate-shaped magnetic material core 110 and a flexible printed circuit (FPC) board 111 including the SMT lands 22, and the terminal ends 12a and 12b of the coil wire 12 are temporarily fixed to the SMT lands 22.

Referring to FIG. 6, the flexible printed circuit board 111 is an assembly board in which multiple elements are arranged. Each element is not limited to particular dimensions. For example, a dimension indicated by double-headed arrow a in FIG. 6 may be 6 mm, and a dimension indicated by double-headed arrow b in FIG. 6 may be 24 mm.

Referring to FIG. 7, the magnetic material core 110 is a ferrite core having a rectangular plate shape. A single-sided adhesive sheet 113, which is a polyimide with an adhesive material, is adhered to a first surface (a lower surface in the state of FIG. 7) of the magnetic material core 110. Meanwhile, a heat-resistant double-sided adhesive sheet 112 is adhered to a second surface (an upper surface in the state of FIG. 7) of the magnetic material core 110. Then, the flexible printed circuit board 111 is adhered to the magnetic material core 110 via the heat-resistant double-sided adhesive sheet 112, so that a laminate is obtained.

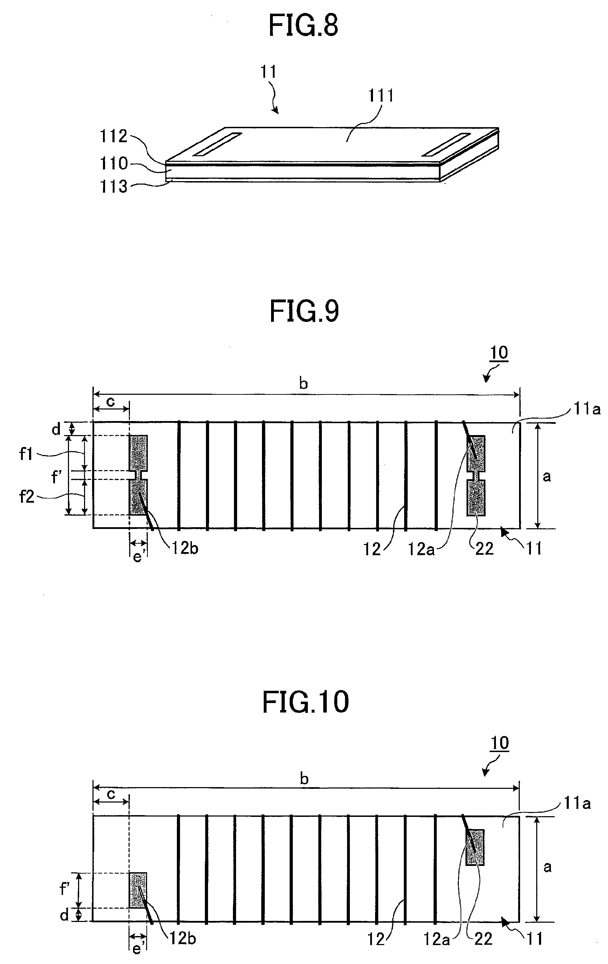

The obtained laminate is divided along dividing lines indicated by dotted lines in FIG. 6 into individual pieces as illustrated in FIG. 8. Each obtained individual piece is used for the manufacture of the coil antenna 10 as the coil antenna body 11.

The coil wire 12 is wound around the coil antenna body 11, and the terminal ends 12a and 12b of the coil wire 12 are temporarily fixed to the SMT lands 22 by thermocompression bonding, so that the coil antenna 10 is formed.

FIG. 9 and FIG. 10 illustrate examples of the coil antenna 10 according to this embodiment.

As illustrated in FIG. 9 and FIG. 10, by providing the two SMT lands 22 in total, one on each end side of the coil antenna body 11, it becomes easy to maintain the horizontalness of the coil antenna 10 relative to the mounting base 30 when the surface 11a of the coil antenna body 11 on which the SMT lands 22 are provided and the mounting base 30 are joined, so that it is possible to suppress variations in the antenna performance of the coil antenna 10. By the arrangement illustrated in FIG. 10, it is possible to stabilize the horizontalness of the coil antenna 10 in its longitudinal direction. By the arrangement illustrated in FIG. 9, it is possible to stabilize the horizontalness of the coil antenna 10 in the transverse direction as well as the longitudinal direction of the coil antenna 10, so that it is possible to attach the coil antenna 10 to the mounting base 30 while maintaining the horizontalness of the coil antenna 10 with more reliability.

The coil antenna 10 is not limited to particular dimensions. In the case of FIG. 9, when the external dimensions of the coil antenna body 11 in its transverse direction and longitudinal direction indicated by double-headed arrows a and b are 6 mm and 24 mm, respectively, a dimension indicated by double-headed arrow c may be 2.0 mm, a dimension indicated by double-headed arrow d may be 0.75 mm, a dimension indicated by double-headed arrow e' may be 1.0 mm, a dimension indicated by double-headed arrow f' may be 4.5 mm, and each of dimensions indicated by double-headed arrows f1 and f2 may be 2.0 mm.

Furthermore, in the case of FIG. 10, likewise, when the external dimensions of the coil antenna body 11 in its transverse direction and longitudinal direction indicated by double-headed arrows a and b are 6 mm and 24 mm, respectively, the dimension indicated by double-headed arrow c may be 2.0 mm, the dimension indicated by double-headed arrow d may be 0.75 mm, the dimension indicated by double-headed arrow e' may be 1.0 mm, and the dimension indicated by double-headed arrow f' may be 2.0 mm.

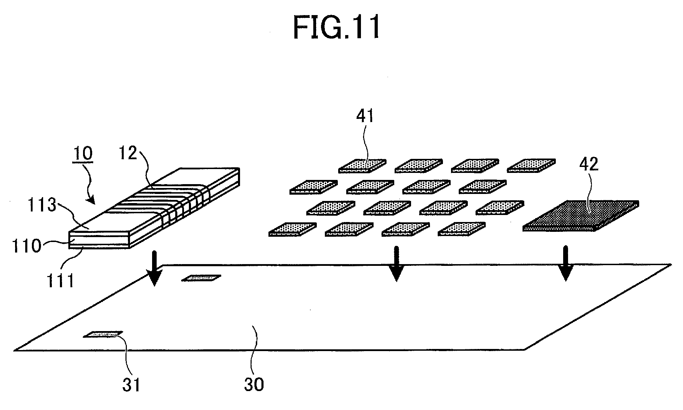

Then, as illustrated in FIG. 11, the coil antenna 10 is disposed on the mounting base 30 so that the SMT lands 22 and the coil wire 12 come into contact with the antenna connection patterns 31 of the mounting base 30, and a solder flow process is performed to solder the coil antenna 10, together with other mounting parts such as chip resistor (CR)s 41 and a wafer-level chip size package (WLCSP) 42, to the mounting base 30.

The "solder flow process" refers to causing an object to pass through a solder flow bath or a reflow apparatus.

The coil antenna 10 manufactured according to any of the above-described manufacturing methods may be efficiently mounted while being kept thin. According to the coil antenna package manufactured according to any of the above-described manufacturing methods, an increase in thickness due to the joining of the coil antenna 10 and the mounting base 30 is suppressed. Accordingly, the manufactured coil antenna package is suitable as a component to be mounted on various types of portable terminals, such as radio communication devices including smartphones, that are desired to be reduced in size and thickness.

All examples and conditional language provided herein are intended for pedagogical purposes of aiding the reader in understanding the invention and the concepts contributed by the inventors to further the art, and are not to be construed as limitations to such specifically recited examples and conditions, nor does the organization of such examples in the specification relate to a showing of the superiority or inferiority of the invention. Methods of manufacturing a coil antenna and methods of manufacturing a coil antenna package have been described in detail based on one or more embodiments of the present invention. It should be understood, however, that the various changes, substitutions, and alterations could be made hereto without departing from the spirit and scope of the present invention.

The present application is based upon and claims the benefit of priority of Japanese Patent Application No. 2013-237676, filed on November 18, 2013, the entire contents of which are incorporated herein by reference.

### Description of Reference Numerals

10 coil antenna
11 coil antenna body
11a surface facing a mounting base
11b surface opposite to the surface facing a mounting base
110 magnetic material core
111 flexible printed circuit (FPC) board
112 heat-resistant double-sided adhesive sheet
113 single-sided adhesive sheet
12 coil wire
12a, 12b terminal end of the coil wire
20 antenna connection pattern contact part
22 SMT land
23 pre-soldered part
30 mounting base
31 antenna connection pattern
41 chip resistor (CR)
42 wafer-level chip size package (WLCSP)

## Claims

1. A method of manufacturing a coil antenna, the coil antenna including a flexible plate-shaped coil antenna body containing a magnetic material, and a coil wire wound around the coil antenna body in a direction perpendicular to a longitudinal direction of the coil antenna body so as to form a loop, the method comprising the steps of:
temporarily fixing a terminal end of the coil wire to the coil antenna body; and
performing treatment on a part of the coil wire that comes into contact with a connection part of a mounting base on which the coil antenna is to be mounted, so that the coil antenna is electrically connectable to the mounting base.

2. The method of manufacturing a coil antenna as claimed in claim 1, wherein the terminal end of the coil wire is temporarily fixed to a surface of the coil antenna body other than a surface of the coil antenna body that faces the mounting base.

3. The method of manufacturing a coil antenna as claimed in claim 1 or 2, wherein the terminal end of the coil wire is temporarily fixed to a surface of the coil antenna body adjoining a surface of the coil antenna body that faces the mounting base.

4. The method of manufacturing a coil antenna as claimed in claim 1, wherein the terminal end of the coil wire is temporarily fixed to a surface of the coil antenna body that faces the mounting base.

5. The method of manufacturing a coil antenna as claimed in claim 1, wherein the coil antenna body includes a plate-shaped magnetic material core and a flexible printed circuit board including an antenna terminal, and the terminal end of the coil wire is temporarily fixed to the antenna terminal.

6. The method of manufacturing a coil antenna as claimed in any of claims 1 to 5, wherein the treatment pre-solders the part of the coil wire that comes into contact with the connection part of the mounting base.

7. A method of manufacturing a coil antenna package, the coil antenna package including a coil antenna that includes a flexible plate-shaped coil antenna body containing a magnetic material, and a coil wire wound around the coil antenna body in a direction perpendicular to a longitudinal direction of the coil antenna body so as to form a loop; and a mounting base on which the coil antenna is surface-mounted, the mounting base including a connection part at a position where the mounting base is connected to the coil antenna, the method comprising the steps of:
temporarily fixing a terminal end of the coil wire to the coil antenna body;
performing treatment on a part of the coil wire that comes into contact with the connection part of the mounting base, so that the coil antenna is electrically connectable to the mounting base; and
disposing the coil antenna on the mounting base so that the part of the coil wire comes into contact with the connection part, and joining the coil antenna to the mounting base with solder flow.
